# EUROPEAN PATENT APPLICATION

(11) **EP 4 258 045 A1**
(43) Date of publication of application: **11.10.2023**
(21) Application number: 21899810.2
(22) Date of filing: 08.11.2021
(51) Int. Cl.: G02F 1/01, H01L 27/32

(54) **POLARIZER STRUCTURE, TERMINAL DEVICE, AND METHOD FOR CONTROLLING AMOUNT OF INCOMING LIGHT OF TERMINAL DEVICE**

(30) Priority: 04.12.2020 CN 202011409767
(71) Applicant: ZTE Corporation, Shenzhen, Guangdong 518057 (CN)
(72) Inventor: ZHANG, Xiaoliang, Shenzhen, Guangdong 518057 (CN)
(74) Representative: Blumbach · Zinngrebe Patentanwälte PartG mbB
(86) International application number: PCT/CN2021/129215
(87) International publication number: WO 2022/116776

(57) **Abstract**

The present disclosure provides a polarizer structure, including a first polarizer, a first electrode, and a second electrode, the first electrode and the second electrode are respectively attached to two opposite surfaces of the first polarizer, and the first electrode and the second electrode are configured to enable or disable a polarization function of the first polarizer according to applied voltage. The present disclosure further provides a terminal device and a method for controlling amount of incoming light of a terminal device.

## Description

### TECHNICAL FIELD

The present disclosure relates to the field of display technology, and in particular, to a polarizer structure, a terminal device, and a method for controlling amount of incoming light of a terminal device.

### BACKGROUND

All screen or high screen ratio is an important development direction of mobile phones, and a front under-display camera is a technical solution capable of maximizing the screen ratio.

At present, a cathode of a display pixel on an Active-Matrix Organic Light-Emitting Diode (AMOLED) display screen is generally formed from a metal with small resistivity, such as a silver wire. Since such metal has high reflectivity, ambient light from outside is reflected after reaching the display screen. Strong reflected light cause the light emitted from the display screen to be covered, which makes display contrast of the display screen poorer. In order to solve such problem, a polarizer and a quarter-wave plate may be attached to a surface of the display screen to absorb the reflected ambient light, so as to improve the contrast of the display screen. The front under-display camera needs to collect enough amount of light, so that light transmittance of a camera region needs to be increased. However, when natural light passes through the polarizer, in general, the light having a polarization direction consistent with a direction of an absorption axis is absorbed, and merely the light having a polarization direction consistent with a direction of a transmission axis can pass through the polarizer, which causes absorption of 50% of the natural light, resulting in relatively low light transmittance.

In order to take account of both contrast of a displayed image and the light transmittance of a region where the front under-display camera is located, all current solutions of the front under-display camera cause damage to the polarizer, with the result that reflection of the ambient light in the camera region is enhanced, the display contrast becomes poorer, and a difference between contrast in the camera region and contrast in a non-camera region in the display screen becomes more obvious when brightness of the ambient light around is relatively high, thus seriously affecting a display effect.

### SUMMARY

The present disclosure provides a polarizer structure, a terminal device, and a method for controlling amount of incoming light of a terminal device.

An embodiment of the present disclosure provides a polarizer structure, including a first polarizer, a first electrode, and a second electrode. The first electrode and the second electrode are respectively attached to two opposite surfaces of the first polarizer; and the first electrode and the second electrode are configured to enable or disable a polarization function of the first polarizer according to applied voltage.

An embodiment of the present disclosure further provides a terminal device, including a display unit configured to display an image, an image capture unit configured to capture an image from outside of the terminal device, and the polarizer structure according to the present disclosure. An orthographic projection of the polarizer structure on the display unit at least partially coincides with an orthographic projection of the image capture unit on the display unit.

An embodiment of the present disclosure further provides a method for controlling amount of incoming light of a terminal device applied to the terminal device according to the present disclosure, including: in response to reception of a first control instruction, capturing an image from outside of the terminal device, and applying a first voltage to the first electrode and the second electrode.

### BRIEF DESCRIPTION OF DRAWINGS

FIG. 1 is a schematic diagram of a polarizer structure according to the present disclosure;
FIG. 2A is a block diagram of a terminal device according to the present disclosure;
FIG. 2B is a schematic diagram of display regions of the terminal device according to the present disclosure;
FIG. 3A is a schematic diagram illustrating an optical path of a terminal device in an operating state of a camera according to the present disclosure; and
FIG. 3B is a schematic diagram illustrating an optical path of a terminal device in a non-operating state of a camera according to the present disclosure.

### DETAIL DESCRIPTION OF EMBODIMENTS

Exemplary embodiments of the present disclosure will be described more fully below with reference to the drawings, but the exemplary embodiments described herein may be embodied in different forms and should not be interpreted as being limited to embodiments described herein. Rather, the embodiments are provided to make the present disclosure thorough and complete, and are intended to enable those of ordinary skill in the art to fully understand the scope of the present disclosure.

The term "and/or" used herein includes any and all combinations of one or more associated listed items.

The terms used herein are merely used to describe specific embodiments, and are not intended to limit the present disclosure. As used herein, "a" and "the" which indicate a singular form are intended to include a plural form, unless expressly stated in the context. It should be further understood that the term(s) "comprise" and/or "be made of" used herein indicate(s) the presence of the described features, integers, operations, elements and/or components, but do not exclude the presence or addition of one or more other features, integers, operations, elements, components and/or combinations thereof.

The embodiments described herein can be described with reference to plans and/or cross-sectional views with the aid of idealized schematic diagrams of the present disclosure. Accordingly, the exemplary drawings may be modified according to manufacturing techniques and/or tolerances. The embodiments are not limited to those illustrated by the drawings, but include modifications to configuration formed based on a manufacturing process. Thus, regions shown in the drawings are illustrative, and shapes of the regions shown in the drawings illustrate specific shapes of regions of elements, but are not intended to make limitations.

Unless otherwise defined, all terms (including technical and scientific terms) used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein.

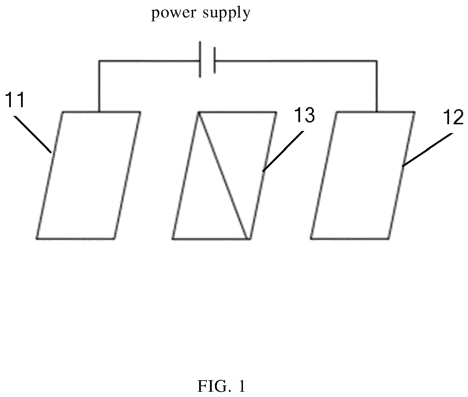

The present disclosure provides a polarizer structure. As shown in FIG. 1, the polarizer structure includes a first electrode 11, a second electrode 12, and a first polarizer 13. The first electrode 11 and the second electrode 12 are respectively attached to two opposite surfaces of the first polarizer 13. The first electrode 11 and the second electrode 12 are configured to enable or disable a polarization function of the first polarizer 13 according to applied voltage.

With the polarizer structure provided by the present disclosure, the polarization function of the polarizer can be enabled or disabled, and the polarizer structure can be applied in a region of a front under-display camera of a terminal device. Thus, without damaging the polarizer, an amount of incoming light can be increased in an operating state of the camera, and consistency between contrast of a camera region and contrast of a non-camera region in a display screen can be ensured in a non-operating state of the camera, thereby improving a display effect.

In some embodiments, when no voltage is applied to the first electrode 11 and the second electrode 12, the polarization function of the first polarizer 13 may be enabled; and when the first electrode 11 and the second electrode 12 are applied with a first voltage having the same magnitude and opposite polarities, the polarization function of the first polarizer 13 may be disabled, with the magnitude of the first voltage being greater than a preset threshold.

That is, the first electrode 11 and the second electrode 12 may serve as a "switch" of the first polarizer 13: when the polarization function of the first polarizer 13 is needed, for example, when an image needs to be displayed, no voltage is applied to the first electrode 11 and the second electrode 12, thereby enabling the polarization function of the first polarizer 13; and when the polarization function of the first polarizer 13 is not needed, for example, when light transmittance needs to be increased, voltage greater than the preset threshold may be applied to the first electrode 11 and the second electrode 12 to disable the polarization function of the first polarizer 13, thereby allowing the light to be directly transmitted through the polarizer structure.

In some embodiments, the first polarizer 13 may be a carbon nanotube polarizer. A change in the voltages of the first electrode 11 and the second electrode 12 may change distribution of carbon elements in a carbon nanotube material, thereby changing a polarization degree of the first polarizer 13.

In some embodiments, the first electrode 11 and the second electrode 12 may be transparent electrodes. Thus, when the polarization function of the first polarizer 13 is disabled, it may be ensured that the light penetrates through the polarizer structure to reduce a loss of amount of incoming light of the under-display camera. In some embodiments, the first electrode 11 and the second electrode 12 may adopt electrodes made of Indium Tin Oxide (ITO).

According to the embodiments of the present disclosure, by attaching the transparent conductive layers (e.g., the ITO layers) to the two surfaces of the carbon nanotube polarizer, and applying the voltage to the transparent conductive layers to temporarily disable the polarization function of the carbon nanotube polarizer, the carbon nanotube polarizer stops absorbing the light having a polarization direction parallel to an absorption axis, which frees the light entering the front under-display camera from an influence of the carbon nanotube polarizer, thereby increasing the amount of incoming light.

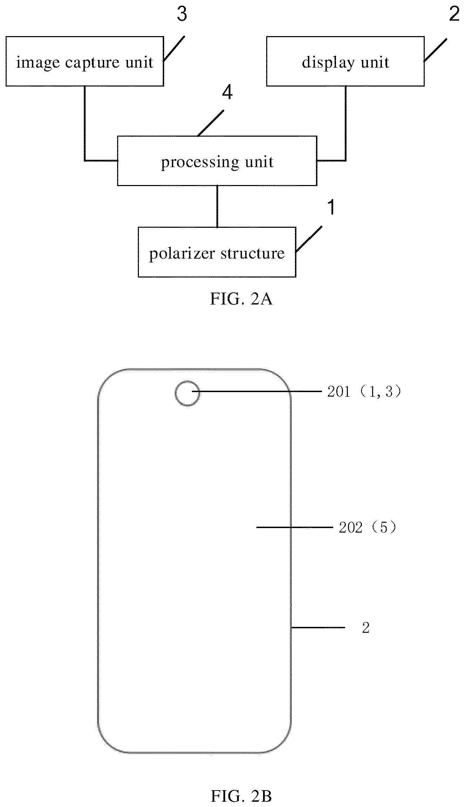

Based on the same technical idea, the present disclosure further provides a terminal device. With reference to FIG. 2A and FIG. 2B, the terminal device includes a polarizer structure 1, a display unit 2 configured to display an image, and an image capture unit 3 configured to capture an image from outside of the terminal device. The polarizer structure 1 is the polarizer structure provided by the present disclosure, and an orthographic projection of the polarizer structure 1 on the display unit 2 at least partially coincides with that of the image capture unit 3 on the display unit 2.

The display unit 2 may be a display screen, and the image capture unit 3 may be a front under-display camera. The front under-display camera refers to a case where the front camera is completely built under the display screen and no opening is formed in the display screen for exposing the camera, thus realizing a real all screen. A region where the polarizer structure 1 is located at the display unit 2 at least partially overlaps a region where the image capture unit 3 is located at the display unit 2, that is, the polarizer structure 1 at least partially covers the image capture unit 3. It should be noted that the polarizer structure 1 may be disposed on a side of the display unit 2 away from the image capture unit 3, that is, the polarizer structure 1 may be closer to a user of the terminal device than the display unit 2.

A case where the terminal device is a mobile phone is taken as an example in the embodiments of the present disclosure, but those of ordinary skill in the art should be aware that any all-screen terminal device with a display function and an image capturing function falls within the scope of the present disclosure.

In the terminal device provided by the present disclosure, the polarizer structure is located in the region where the front under-display camera is disposed at the terminal device, and a polarization function of the polarizer structure can be enabled or disabled. Thus, without damaging the polarizer, an amount of incoming light can be increased in an operating state of the camera, and consistency between contrast of a camera region and contrast of a non-camera region in the display screen can be ensured in a non-operating state of the camera, thereby improving a display effect of the terminal device.

In some embodiments, the orthographic projection of the polarizer structure 1 on the display unit 2 completely covers that of the image capture unit 3 on the display unit 2, that is, the polarizer structure 1 completely covers the image capture unit 3. Thus, amount of incoming light of the image capture unit 3 can be increased, and a display effect of the display unit 2 can be optimized.

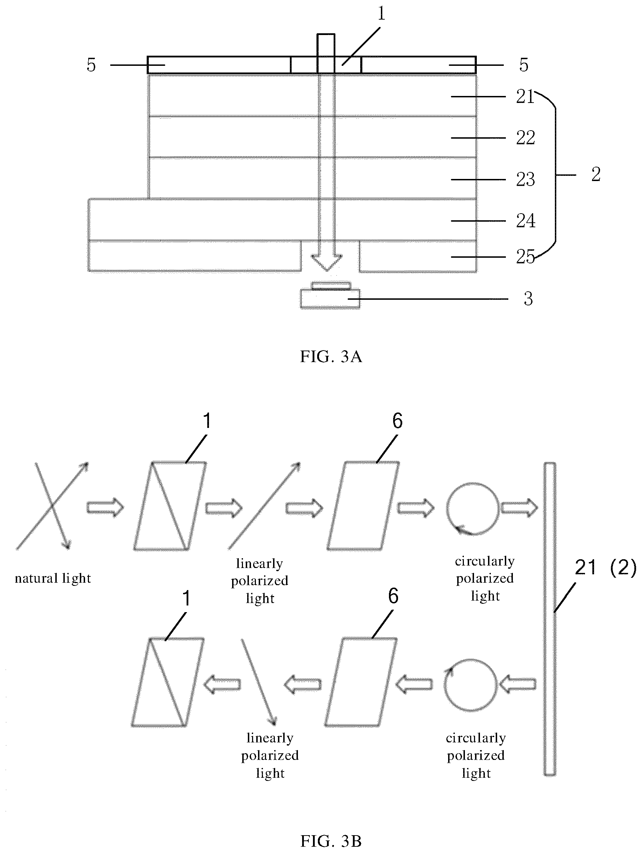

A case where the display unit 2 is an AMOLED display screen is taken as an example for illustration in the embodiments of the present disclosure. As shown in FIG. 3A, the display unit 2 includes a cathode 21, an organic light-emitting layer 22, an anode 23, and a base substrate 24. The organic light-emitting layer 22 is located between the cathode 21 and the anode 23, and the anode 23 is formed on the base substrate 24. The cathode 21 and the anode 23 are both made of a transparent conductive material such as ITO. The base substrate 24 is made of a transparent material such as glass or plastic. The cathode 21 provides electrons for the organic light-emitting layer 22, the anode 23 provides holes for the organic light-emitting layer 22, and the organic light-emitting layer 22 is composed of molecules of an organic light-emitting material. The electrons injected from the cathode 21 and the holes injected from the anode 23 are combined in the organic light-emitting layer 22 to form excitons, and de-excitation of exciton radiation occurs to generate photons, thereby producing visible light. The organic light-emitting layer 22 serves as a light emitting layer of the display unit 2, and the light emitted from the organic light-emitting layer 22 is transmitted through the cathode 21 after certain voltages are applied to the cathode 21 and the anode 23, thereby realizing image display. The display unit 2 may further include light-shielding foam 25 for hiding metal wires of the display unit 2 and internal devices of the terminal device. The light-shielding foam 25 may be disposed on a side of the glass substrate 24 away from the anode 23, and provided with an opening, and the image capture unit 3 is located in a region where the opening is located.

It should be noted that those of ordinary skill in the art are aware that the display unit 2 may also be a Passive Matrix OLED (PMOLED) display screen.

In some embodiments, with reference to FIG. 2A and FIG. 1, the terminal device may further include a processing unit 4. When receiving a first control instruction, the processing unit 4 may control the image capture unit 3 to be turned on, and control to apply the first voltage greater than a preset threshold to the first electrode 11 and the second electrode 12, so as to disable the polarization function of the first polarizer 13. The processing unit 4 may be a core processor of the terminal device, such as a Central Processing Unit (CPU), and the first control instruction may be a control instruction to take a picture or shoot, which requires the image capture unit 3 to operate.

It should be noted that the first electrode 11 and the second electrode 12 may be connected to a motherboard of the terminal device through wires, and the first voltage is supplied by the motherboard.

An optical path in an operating state of the image capture unit 3 is described in detail below with reference to FIG. 3A.

As shown in FIG. 3A, the processing unit 4 may control the image capture unit 3 to be turned on, and nothing is displayed in the region (i.e., the region of the light shielding foam 25 where the opening is formed) where the image capture unit 3 is located at the display unit 2. Moreover, the processing unit 4 may control to apply the first voltage greater than the preset threshold to the first electrode 11 and the second electrode 12 to disable the polarization function of the first polarizer 13 (that is, the polarizer structure 1 may be temporarily disabled), so that the polarizer structure 1 may directly transmit the ambient light. The ambient light may enter the image capture unit 3 without being reflected by the cathode 21, which increases the amount of incoming light of the image capture unit 3, and ensures a shooting effect of the image capture unit 3.

In some embodiments, when receiving a second control instruction, the processing unit 4 may control the display unit 2 to display an image to be displayed, and stop applying the first voltage to the first electrode 11 and the second electrode 12. The second control instruction may be a control instruction to display an image, which needs a display function of the display unit 2.

In some embodiments, as shown in FIG. 2B, the display unit 2 may include a first display region 201 and a second display region 202, the orthographic projection of the polarizer structure 1 on the display unit 2 coincides with that of the image capture unit 3 on the display unit 2, and the polarizer structure 1 and the image capture unit 3 are located in the first display region 201. The first display region 201 is shown as a circular region in FIG. 2B, i.e., the region where the front under-display camera is located, and is also the region where the polarizer structure 1 is located, and the first display region 201 is a light-transmitting region of the front under-display camera. With reference to FIG. 2A, FIG. 3A, and FIG. 3B, the terminal device may further include a second polarizer 5 located in the second display region 202. When no voltage is applied to the first electrode 11 and the second electrode 12, a polarization degree of the first polarizer 13 is the same as that of the second polarizer 5.

In some embodiments, as shown in FIG. 3B, the terminal device may further include a quarter-wave plate 6 located between the polarizer structure 1 and the display unit 2 and covering the whole display unit 2 (i.e., covering the first display region 201 and the second display region 202). The quarter-wave plate 6 can convert linearly polarized light emitted from the polarizer structure 1 into circularly polarized light.

In the embodiments of the present disclosure, two types of polarizers are provided on an outer side of the display unit 2: one is the normal polarizer (i.e., the second polarizer 5) in the second display region 202, and a polarization function of the second polarizer 5 always works; and the other is the polarizer (i.e., the polarizer structure 1) with the polarizing function capable of being enabled/disabled in the first display region 201. When the terminal device needs to use the display function, the polarization function of the polarizer structure 1 is enabled, and polarization degrees in all the regions of the display unit 2 are consistent with each other, so that consistency of display contrast of the whole display screen may be ensured.

An optical path in a non-operating state of the image capture unit 3 is described in detail below with reference to FIG. 1, FIG. 2A, and FIG.3B.

As shown in FIG. 3B, when an image needs to be displayed, the processing unit 4 stops applying the first voltage to the first electrode 11 and the second electrode 12 (i.e., removing the first voltage applied to the first electrode 11 and the second electrode 12). Since no voltage is applied to the first electrode 11 and the second electrode 12, the polarization function of the first polarizer 13 is enabled, and the polarizer structure 1 is restored to a polarization state. Thus, the ambient light is uniformly polarized in all directions, and merely the light having a polarization direction perpendicular to an absorption axis may pass through the polarizer structure 1 to become the linearly polarized light after the ambient light passes through the polarizer structure 1 with the polarization function enabled. The linearly polarized light is converted into the circularly polarized light by the quarter-wave plate 6 and then enters the cathode 21 of the display unit 2. The cathode 21 may reflect the incident ambient light (the circularly polarized light) out, and the quarter-wave plate 6 converts the circularly polarized light into the linearly polarized light, and then the linearly polarized light enters the polarizer structure 1. Since the reflected ambient light is rotated by 90 degrees, the reflected ambient light may be absorbed by the polarizer structure 1. Thus, reflection of the ambient light is reduced, the display contrast is improved, and the display effect is enhanced.

Based on the same technical idea, the present disclosure further provides a method for controlling amount of incoming light of a terminal device, and the method is applied to the terminal device provided by the present disclosure. The method includes: in response to reception of a first control instruction, capturing an image from outside of the terminal device, and applying a first voltage to the first electrode and the second electrode, with a magnitude of the first voltage greater than a preset threshold.

In this operation, when receiving the first control instruction, the processing unit 4 controls the image capture unit 3 to be turned on to capture the image from the outside of the terminal device, and applies the first voltage to the first electrode 11 and the second electrode 12 to disable a polarization function of the first polarizer 13, thereby increasing the amount of incoming light of the image capture unit 3, and ensuring the shooting effect of the image capture unit 3.

In some embodiments, the method for controlling amount of incoming light of a terminal device may further include: in response to reception of a second control instruction to display an image to be displayed, stopping applying the first voltage to the first electrode and the second electrode.

In this operation, when receiving the second control instruction, the processing unit 4 controls the display unit 2 to display the image to be displayed, and stops applying the first voltage to the first electrode 11 and the second electrode 12 to enable the polarization function of the first polarizer 13, thereby reducing the reflection of the ambient light, improving the display contrast, and enhancing the display effect.

After receiving the first control instruction (e.g., an instruction to turn on a front under-display camera), the processing unit 4 turns on the image capture unit 3 (i.e., the front under-display camera), and meanwhile, nothing is displayed in a region (i.e., a display screen) where the front under-display camera is located at the display unit 2, the region is locally transparent, and the light may enter the front under-display camera through the region. The processing unit 4 applies the first voltage to the first electrode 11 and the second electrode 12 (i.e., two transparent electrodes) of the polarizer structure 1, so that the first polarizer 13 (i.e., a carbon nanotube polarizer) is temporarily disabled and does not have the polarization function, and the light parallel to the absorption axis of the first polarizer 13 is not absorbed by the polarizer structure 1 when passing through the polarizer structure 1. After the front under-display camera captures an image, the captured image may be sent to the processing unit 4, the processing unit 4 sends the image to the display screen for display, and meanwhile, the processing unit 4 may stop applying the first voltage to the first electrode 11 and the second electrode 12 to restore the polarization function of the first polarizer 13, so that the light parallel to the absorption axis may be absorbed, resulting in consistency in contrast of the whole display screen.

In order to prevent the display effect from deteriorating, the polarization degree of the polarizer structure 1 is not changed when the terminal device performs display normally, so that the polarizer structure 1 can absorb the reflected light around to ensure normal contrast of the display screen; and when the front under-display camera is used, the polarization degree of the first polarizer 13 is changed by applying the first voltage to an upper side and a lower side of the first polarizer 13 to increase the light transmittance, so as to allow more light to enter the front under-display camera, thereby increasing an amount of light collected by the front under-display camera, and enhancing a photographing effect.

A polarization state of the carbon nanotube polarizer can be changed by applying the first voltage to the ITO layers on two sides of the carbon nanotube polarizer, so that the carbon nanotube polarizer has different polarization degrees in a photographing state and a non-photographing state. The polarization function of the polarizer is disabled in the photographing state to allow more light to enter the front under-display camera; and the polarization function of the polarizer is restored in the non-photographing state to allow the reflected light to be absorbed, thereby improving the display contrast. On the one hand, the display screen can be kept to have good display contrast when performing display, and on the other hand, the amount of incoming light of the front under-display camera can be greatly increased, thereby improving the photographing effect of the front under-display camera.

It should be understood by those of ordinary skill in the art that the functional modules/units in all or some of the operations and devices in the method disclosed above may be implemented as software, firmware, hardware, or suitable combinations thereof. If implemented as hardware, the division between the functional modules/units stated above is not necessarily corresponding to the division of physical components; for example, one physical component may have a plurality of functions, or one function or operation may be performed through cooperation of several physical components. Some or all of the physical components may be implemented as software executed by a processor, such as a central processing unit, a digital signal processor or a microprocessor, or may be implemented as hardware, or may be implemented as an integrated circuit, such as an application specific integrated circuit. Such software may be distributed on a computer-readable medium, which may include a computer storage medium (or a non-transitory medium) and a communication medium (or a transitory medium). As well known by those of ordinary skill in the art, the term "computer storage medium" includes volatile/nonvolatile and removable/non-removable media used in any method or technology for storing information (such as computer-readable instructions, data structures, program modules and other data). The computer storage medium includes, but is not limited to, a Random Access Memory (RAM), a Read-Only Memory (ROM), an Electrically Erasable Programmable Read-Only Memory (EEPROM), a flash memory or other memory techniques, a Compact Disc Read Only Memory (CD-ROM), a Digital Versatile Disc (DVD) or other optical discs, a magnetic cassette, a magnetic tape, a magnetic disk or other magnetic storage devices, or any other medium which can be configured to store desired information and can be accessed by a computer. In addition, it is well known by those of ordinary skill in the art that the communication media generally include computer-readable instructions, data structures, program modules, or other data in modulated data signals such as carrier wave or other transmission mechanism, and may include any information delivery medium.

The present disclosure discloses the exemplary embodiments using specific terms, but the terms are merely used and should be merely interpreted as having general illustrative meanings, rather than for the purpose of limitation. Unless expressly stated, it is apparent to those of ordinary skill in the art that features, characteristics and/or elements described in connection with a particular embodiment can be used alone or in combination with features, characteristics and/or elements described in connection with other embodiments. Therefore, it should be understood by those of ordinary skill in the art that various changes in the forms and the details can be made without departing from the scope of the present disclosure of the appended claims.

## Claims

1. A polarizer structure, comprising a first polarizer, a first electrode, and a second electrode,
wherein the first electrode and the second electrode are respectively attached to two opposite surfaces of the first polarizer, and
the first electrode and the second electrode are configured to enable or disable a polarization function of the first polarizer according to applied voltage.

2. The polarizer structure of claim 1, wherein
upon a condition of no voltage being applied to the first electrode and the second electrode, the polarization function of the first polarizer is enabled; and
upon a condition of the first electrode and the second electrode being applied with a first voltage having same magnitude and opposite polarities respectively, the polarization function of the first polarizer is disabled, wherein a magnitude of the first voltage is greater than a preset threshold.

3. The polarizer structure of claim 1, wherein the first polarizer is a carbon nanotube polarizer.

4. The polarizer structure of any one of claims 1 to 3, wherein the first electrode and the second electrode are transparent electrodes.

5. A terminal device, comprising:
a display unit configured to display an image;
an image capture unit configured to capture an image from the outside of the terminal device; and
the polarizer structure of any one of claims 1 to 4,
wherein an orthographic projection of the polarizer structure on the display unit at least partially coincides with an orthographic projection of the image capture unit on the display unit.

6. The terminal device of claim 5, further comprising a processing unit, wherein upon a condition of receiving a first control instruction, the processing unit controls the image capture unit to be turned on, and applies a first voltage having a magnitude greater than a preset threshold to the first electrode and the second electrode, so as to control to disable the polarization function of the first polarizer.

7. The terminal device of claim 6, wherein upon a condition of receiving a second control instruction, the processing unit controls the display unit to display an image to be displayed, and stops applying the first voltage to the first electrode and the second electrode, so as to control to enable the polarization function of the first polarizer.

8. The terminal device of claim 7, wherein the display unit comprises a first display region and a second display region, the orthographic projection of the polarizer structure on the display unit coincides with the orthographic projection of the image capture unit on the display unit, and the polarizer structure and the image capture unit are located in the first display region.

9. The terminal device of claim 8, further comprising a second polarizer located in the second display region,
wherein upon the condition of no voltage being applied to the first electrode and the second electrode, a polarization degree of the first polarizer is the same as a polarization degree of the second polarizer.

10. A method for controlling amount of incoming light of a terminal device applied to the terminal device of any one of claims 5 to 9, comprising:
in response to reception of a first control instruction, capturing an image from outside of the terminal device, and applying a first voltage having a magnitude greater than a preset threshold to the first electrode and the second electrode; and
in response to reception of a second control instruction to display an image to be displayed, stopping applying the first voltage to the first electrode and the second electrode.
